# EUROPEAN PATENT APPLICATION

(11) **EP 2 293 344 A1**
(43) Date of publication of application: **09.03.2011**
(21) Application number: 09766585.5
(22) Date of filing: 11.06.2009
(51) Int. Cl.: H01L 31/04

(54) **SOLAR CELL AND METHOD FOR MANUFACTURING THE SAME**

(30) Priority: 17.06.2008 JP 2008157713
(71) Applicant: Ulvac, Inc., Chigasaki-shi Kanagawa 253-8543 (JP)
(72) Inventor: MIZUNO Yusuke, Sammu-shi Chiba 289-1226 (JP); TAKAHASHI Hirohisa, Sammu-shi Chiba 289-1226 (JP); UKISHIMA Sadayuki, Sammu-shi Chiba 289-1226 (JP); KOMATSU Takashi, Sammu-shi Chiba 289-1226 (JP); ISHIBASHI Satoru, Sammu-shi Chiba 289-1226 (JP)
(74) Representative: Eisenführ, Günther
(86) International application number: PCT/JP2009/060700
(87) International publication number: WO 2009/154137

(57) **Abstract**

This solar cell has: a light transmissive first electrode; a photoelectric conversion layer formed of silicon; a light transmissive buffer layer; and a second electrode formed of a light reflective alloy. The second electrode is formed of a silver alloy including silver (Ag) as a main component with at least one of tin (Sn) and gold (Au) contained therein.

## Description

### TECHNICAL FIELD

The present invention relates to a solar cell having an alloy electrode and a method of manufacturing the solar cell.
Priority is claimed based on Japanese Patent Application No. 2008-157713, filed June 17, 2008, the content of which is incorporated herein by reference.

### BACKGROUND ART

In the past, solar cells have been widely used as photoelectric conversion devices. As this type of solar cell, there are crystalline silicon solar cells in which single-crystalline silicon or polysilicon is used as a semiconductor layer (photoelectric conversion layer) and thin film silicon solar cells in which amorphous silicon and/or microcrystal silicon are used as a semiconductor layer.

Conventional thin film silicon solar cells have a configuration in which, for example, on a glass substrate, an electrode having transparency (transparent electrode) is formed as a first electrode (surface transparent electrode); a semiconductor layer (photoelectric conversion layer) of silicon (amorphous silicon and/or microcrystal silicon) and a light transmissive buffer layer are sequentially formed on the first electrode; a pure metal electrode having reflectivity (repeller) is formed as a second electrode (back surface metal electrode) on the buffer layer; and a protective layer is formed on the second electrode (for example, see Patent Document 1).

The above-mentioned silicon photoelectric conversion layer has a p-i-n junction structure or n-i-p junction structure in which an i-type silicon film, which is excited by incident light and mainly generates electrons and holes, is sandwiched between p-type and n-type silicon films. In addition, in recent years, a tandem structure has become known in which an amorphous silicon photoelectric conversion layer and a microcrystal silicon photoelectric conversion layer are laminated to improve a conversion rate.

First, the sunlight entering a glass substrate passes through the surface transparent electrode and then enters the photoelectric conversion layer. At this time, when energy particles referred to as photons, which are included in the sunlight, hit the i-type silicon, electrons and holes are generated by a photovoltaic effect. The electrons move toward the n-type silicon and the holes move toward the p-type silicon. By taking out the electrons and holes from the surface transparent electrode and the back surface metal electrode, respectively, the light energy can be converted into the electric energy. Meanwhile, the light transmitted through the photoelectric conversion layer is reflected by the surface of the back surface metal electrode and then once again directed to the photoelectric conversion layer. As a result, electrons and holes are generated in the photoelectric conversion layer and the light energy is thus converted into the electric energy.

As the back surface metal electrode, a silver (Ag) electrode having low resistance and high optical reflectance is formed by sputtering. Further, as the buffer layer, for example, an AZO (ZnO with A1 added thereto) film or a GZO (ZnO with Ga added thereto) film is formed. The buffer layer functions as a barrier layer between the photoelectric conversion layer and the back surface metal electrode.

Meanwhile, there is a technology of forming an alloy including Ag with Sn and Au added thereto on a substrate by sputtering (for example, see Patent Documents 2 to 4). The alloy which includes Ag as a main component with Sn and Au added thereto has high reflectance and is excellent in adhesion with the substrate.

### Citation List

### [Patent Document]

[Patent Document 1] Japanese Unexamined Patent Application, First Publication No. 2007-266095
[Patent Document 2] Japanese Unexamined Patent Application, First Publication No. 2004-197117
[Patent Document 3] Japanese Unexamined Patent Application, First Publication No. 2005-264329
[Patent Document 4] Japanese Unexamined Patent Application, First Publication No. 2006-098856

### DISCLOSURE OF INVENTION

### [Problems to be Solved by the Invention]

In the conventional solar cell, an Ag electrode, which uses Ag as a material for the back surface metal electrode, is used. In the Ag electrode, silver oxide is formed at the interface between the Ag electrode and the buffer layer as oxide, and thus optical reflectance is lowered. Accordingly, the light transmitted through the photoelectric conversion layer cannot be sufficiently reflected in some cases. When the light intensity reflected by the Ag electrode and returning to the photoelectric conversion layer decreases, a problem occurs in that the incident photon-to-current conversion efficiency of the solar cell is lowered. In addition, in the Ag electrode, due to a difference or the like in the coefficient of expansion between the Ag electrode and the buffer layer positioned on the Ag electrode, holes are formed at the interface between the Ag electrode and the buffer layer in some cases. When contact resistance increases due to insufficient adhesion with the buffer layer, a problem occurs in that the incident photon-to-current conversion efficiency of the solar cell is lowered. That is, the conventional solar cell has a problem in that the reliability and fill factor of the solar cell are decreased by the Ag electrode as the second electrode.

The present invention is contrived in view of the above-described circumstances and an object of the present invention is to provide a solar cell having improved incident photon-to-current conversion efficiency and reliability and a method of manufacturing the solar cell.

### [Means for Solving the Problems]

The present invention employed the following measures to solve the above-mentioned problems and to achieve the object. That is,
(1) A solar cell of the present invention has: a light transmissive first electrode; a photoelectric conversion layer formed of silicon; a light transmissive buffer layer; and a second electrode formed of a light reflective alloy, and the second electrode is formed of a silver alloy including silver (Ag) as a main component with at least one of tin (Sn) and gold (Au) contained therein.
(2) In the solar cell according to (1), the silver alloy may be formed of a material including Ag as a main component with 0.1 to 2.5 of Sn contained therein in terms of atom% units (at%).
(3) In the solar cell according to (1), the silver alloy is formed of a material including Ag as a main component with 0.1 to 4.0 of Au contained therein in terms of atom% units (at%).
(4) In the solar cell according to (1), the silver alloy is formed of a material including Ag as a main component with 0.1 to 2.5 of Sn and 0.1 to 4.0 of Au contained therein in terms of atom% units (at%).

(5) A solar cell manufacturing method of the present invention is a method of manufacturing the solar cell according to (1) and the method has: forming by sputtering the second electrode by using a target including Ag and at least one of Sn and Au.
(6) In the solar cell manufacturing method according to (5), the target may be formed of a material including Ag as a main component with 0.1 to 2.5 of Sn contained therein in terms of atom% units (at%).
(7) In the solar cell manufacturing method according to (5), the target is formed of a material including Ag as a main component with 0.1 to 4.0 of Au contained therein in terms of atom% units (at%).
(8) In the solar cell manufacturing method according to (5), the target is formed of a material including Ag as a main component with 0.1 to 2.5 of Sn and 0.1 to 4.0 of Au contained therein in terms of atom% units (at%).

### [Effects of the Invention]

In a solar cell of the present invention, as the material for a second electrode, an alloy including Ag as a main component with at least one of Sn and Au added thereto is used. In this manner, reflectance of the metal electrode can be improved and adhesion with a buffer layer can be improved. Accordingly, since an increase in contact resistance at the interface is suppressed and incident photon-to-current conversion Efficiency can thus be improved, the incident photon-to-current conversion efficiency and reliability of the solar cell can be improved (the adhesion is improved by adding Sn and reflection characteristics and corrosion resistance are improved by adding Au).

### BRIEF DESCRIPTION OF THE DRAWINGS

FIG. 1 is a partial cross-sectional diagram showing the configuration of a solar cell according to an embodiment of the present invention.
FIG 2 is a graph showing the reflectance characteristics with respect to incident light wavelength in an ASA film constituting a second electrode of the solar cell, with the horizontal axis representing the reflection wavelength and the vertical axis representing reflectance.
FIG 3A is a diagram explaining a peel test for evaluating adhesion of the ASA film constituting the second electrode of the solar cell and is a cross-sectional diagram of a sample A in which an ASA film 21 is formed on a glass substrate 20 by sputtering.
FIG 3B is a diagram explaining a peel test for evaluating adhesion of the ASA film constituting the second electrode of a conventional solar cell and is a cross-sectional diagram of a sample B in which an Ag film 201 having the same film thickness as that of the above-mentioned ASA film is formed on a glass substrate 200 (which is the same as the glass substrate 20) by sputtering.
FIG 3C is a top view showing the results of the peel test of the above-mentioned sample A.
FIG 3D is a top view showing the results of the peel test of the above-mentioned sample B.

### BEST MODE FOR CARRYING OUT THE INVENTION

Hereinafter, an embodiment of the present invention will be described in detail with reference to the drawings. However, the present invention is not limited only thereto and can be variously modified without departing from the gist of the present invention.

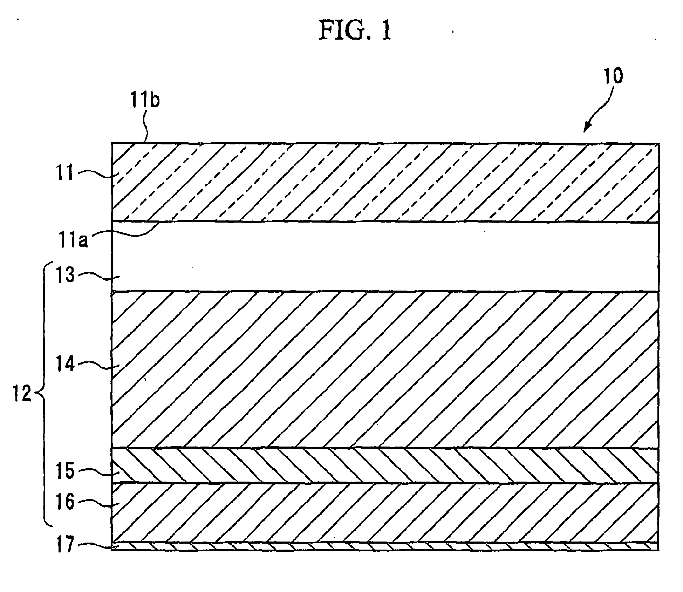

FIG 1 is a partial cross-sectional diagram showing the configuration of a solar cell according to this embodiment. As shown in FIG 1, a solar cell 10 according to this embodiment includes a light transmissive substrate 11, a light transmissive first electrode (surface transparent electrode) 13, a silicon semiconductor layer (photoelectric conversion layer) 14, a light transmissive buffer layer 15, a second electrode (back surface alloy electrode) 16 and a protective layer 17. In the solar cell 10, the first electrode 13, the photoelectric conversion layer 14, the buffer layer 15 and the second electrode 16, which are sequentially laminated on a side (back surface) 11a of the substrate 11, constitute a photoelectric conversion body 12.

### [Substrate 11]

For example, the substrate 11 is formed of an insulating material such as glass or a transparent resin which has durability and excellent permeability of sunlight. In the solar cell 10, sunlight is incident from the opposite side of the photoelectric conversion body 12 with the substrate 11 interposed therebetween, that is, from the other side (surface) 11b of the substrate 11.

### [First Electrode 13]

The first electrode (surface electrode) 13 is formed of light transmissive metal oxide such as AZO (ZnO with A1 added thereto) or GZO (ZnO with Ga added thereto) or transparent conducting oxide (TCO) such as indium tin oxide (ITO), and is formed on the back surface 11a of the substrate 11.

### [Photoelectric Conversion Layer 14]

The silicon photoelectric conversion layer (semiconductor layer) 14 is formed on the first electrode 13. The photoelectric conversion layer 14 has a p-i-n junction structure or n-i-p junction structure in which an i-type silicon film (amorphous silicon film and/or microcrystal silicon) is sandwiched between a p-type silicon film (amorphous silicon film and/or microcrystal silicon) and an n-type silicon film (amorphous silicon film and/or microcrystal silicon). In the photoelectric conversion layer 14, for example, a p-type amorphous silicon film, an i-type amorphous silicon film and an n-type amorphous silicon film are sequentially laminated from the side of the surface transparent electrode 13. On the p-i-n junction structure or n-i-p junction structure of amorphous silicon, a p-i-n junction structure or n-i-p junction structure of microcrystal silicon may be laminated.

When the sunlight passing through the substrate 11 and the surface transparent electrode 13 enters the photoelectric conversion layer 14 and the energy particles included in the sunlight hit the i-type silicon, electrons and holes are generated by a photovoltaic effect. Then, the electrons move toward the n-type silicon and the holes move toward the p-type silicon. By taking out the electrons and holes from the surface transparent electrode 13 and the back surface alloy electrode 16, respectively, the light energy can be converted (photoelectric conversion) into the electric energy.

### [Barrier Layer 15]

The barrier layer 15 is formed of transparent conducting oxide (TCO) such as light transmissive metal oxide having low resistance (for example, AZO (ZnO with A1 added thereto) or GZO (Zn0 with Ga added thereto) having a film thickness of 40 to 100 nm), and is formed between the photoelectric conversion layer 14 and the second electrode 16. The buffer layer 15 functions as a barrier layer for preventing the silicon film of the photoelectric conversion layer 14 from being damaged by the formation of the second electrode 16 by sputtering and preventing silver (Ag), which is a constituent material of the second electrode 16, from being alloyed with the silicon.

In addition, the buffer layer 15 is provided in the migration path of the holes in order to remove from the first electrode 13 the holes which are generated in the i-type silicon by photoelectric conversion. Accordingly, in order not to lower the incident photon-to-current conversion efficiency of the solar cell 10, it is preferable that the buffer layer 15 has conductive properties to preserve the electric conductivity between the photoelectric conversion layer 14 and the first electrode 16, and is formed of a material having low contact resistance. When the photoelectric conversion layer 14 employs a texture structure, it is preferable that the buffer layer is a film that provides excellent coverage during film forming.

### [Back Surface Alloy Electrode 16]

The second electrode (back surface alloy electrode) 16 is an alloy electrode formed of a silver alloy including tin (Sn), gold (Au) and silver (Ag) and is formed on the buffer layer 15. In greater detail, the alloy electrode 16 is an alloy which includes Ag as a main component with Sn and Au added thereto and is formed at a film thickness of, for example, 200 to 250 nm by sputtering.

The alloy electrode 16 functions as an electrode for taking out the holes generated in the photoelectric conversion layer 14. The alloy electrode 16 also has a function of reflecting the light which enters the photoelectric conversion layer 14 via the substrate 11 and the transparent electrode 13, and is transmitted through the photoelectric conversion layer 14 and the buffer layer 15, and returning the light to the photoelectric conversion layer 14 to contribute to the photoelectric conversion.

It is preferable that the ASA (Ag-Sn-Au) film constituting the alloy electrode (second electrode) 16 is formed of 0.1 to 2.5 of Sn, 0.1 to 4.0 of Au and the balance Ag in terms of atom% units (at%). By adjusting the content of Au to 0.1 to 4.0 at%, the reflectance on the long-wavelength side of the light entering the second electrode 16 can be remarkably improved over the case of a conventional Ag electrode and the corrosion resistance of the alloy electrode can be remarkably improved. This is because when the content of Au is less than 0.1 at%, the improvement in reflectance is not remarkable, and when the content of Au is greater than 4.0 at%, cost increases occur and, thus, the above-mentioned effects are offset.

In addition, by adjusting the content of Sn to 0.1 to 2.5 at% in the ASA film constituting the alloy electrode (second electrode) 16, adhesion with the buffer layer 15 can be remarkably improved over the case of a conventional Ag electrode. This is because when the content of Sn is less than 0.1 at%, the improvement in the adhesion properties is not prominent, and when the content of Sn is greater than 2.5 at%, the resistance of the ASA film is increased.

### [Method of Manufacturing Solar Cell 10]

Hereinafter, a method of manufacturing the solar cell 10 of FIG 1 will be described. First, the substrate 11 is provided, and on the back surface 11a of the substrate 11, a TCO film is formed as the first electrode (surface transparent electrode) 13.
Since a glass substrate with TCO is commercially available, it may be provided. However, an AZO film or a GZO film may be formed on a glass substrate by sputtering. In the AZO film-forming sputtering or GZO film-forming sputtering, a ZnO sintered object with A1 or Ga added thereto is used as a target, and a ZnO film is formed under reduced pressure with argon gas as a sputtering gas or under reduced pressure with argon gas with oxygen gas added thereto as a sputtering gas.

Next, on the first electrode 13, a p-type silicon film, an i-type silicon film and an n-type silicon film constituting the photoelectric conversion layer 14 are laminated and formed by a CVD method. On the silicon lamination film, anAZO film or a GZO film constituting the buffer layer 15 is formed by sputtering.

Next, on the GZO film as the buffer layer 15, an ASA film is formed as the alloy electrode (second electrode) 16 by sputtering. In the ASA film-forming sputtering, a target (silver alloy target with 0.1 to 2.5 at% of Sn and 0.1 to 4.0 at% of Au added thereto) including 0.1 to 2.5 at% of Sn, 0.1 to 4.0 at% of Au and the balance Ag in terms of at% is used and the ASA film is formed under reduced pressure with argon gas as a sputtering gas. In the initial stage of the film-forming of the ASA film, it is desirable to add oxygen to the sputtering gas. By adding oxygen only to the film-forming initial stage, adhesion with the GZO film is improved and an increase in contact resistance can be suppressed.

In the ASA film-forming sputtering, an alloy film, which has almost the same composition as that of the target in metal components, can be formed. Accordingly, the ASA film formed becomes a silver alloy film with 0.1 to 2.5 at% of Sn and 0.1 to 4.0 at% of Au added thereto.

In addition, when the back surface of the first electrode 13 is partially exposed by partially removing the areas of the protective film 17, alloy electrode (second electrode) 16, buffer layer 15 and photoelectric conversion layer 14, an area for wire bonding is secured on the first electrode 13. Moreover, when the back surface of the second electrode 16 is partially exposed by partially exposing the area of the protective film 17, an area for wire bonding is secured on the second electrode 16. In this manner, the solar cell 10 of FIG. 1 is manufactured.

### [Optical Reflectance of Alloy Electrode (Second Electrode) 16]

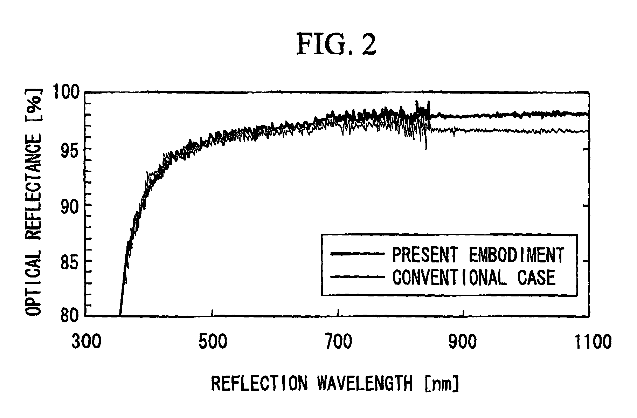

FIG 2 is a graph showing the reflectance characteristics with respect to incident light wavelength in the ASA film constituting the second electrode 16 of the solar cell 10. In FIG. 2, the reflectance characteristics with respect to incident light wavelength in an Ag film constituting the second electrode of a conventional solar cell are also shown as a comparative example. For samples, an ASA film which is used in the present invention and an Ag film which is used in a conventional solar cell are formed at the same film thickness on a glass substrate, respectively.

In an amorphous silicon solar cell, the wavelength of light contributing to the photoelectric conversion is in the range of 300 to 800 nm. As found in FIG. 2, on the long-wavelength side in which the wavelength of the incident light is equal to or greater than 600 nm, the optical reflectance of the ASA film is higher than that in the conventional Ag film. At the incident light wavelength of 700 nm of FIG. 2, the optical reflectance of the Ag film is in the range of 90% to 92% and the optical reflectance of the ASA film is in the range of 94% to 96%. Improvement in the optical wavelength on the long-wavelength side is obtained via the added Au. Accordingly, even when an Ag alloy film including Ag as a main component with Au added thereto and no addition of Sn is used, the above-mentioned improvement in optical reflectance obtained.

In addition, as found in FIG 2, at the incident wavelength shorter than 600 nm, the optical reflectance of the ASA film is the same as in the conventional Ag film. Accordingly, in the solar cell 10 according to this embodiment in which the second electrode 16 is constituted by the ASA alloy, while the optical reflectance at the short-wavelength side of the second electrode 16 is secured so as to be the same as the optical reflectance of the conventional Ag electrode, the optical reflectance at the long-wavelength side can be improved than the optical reflectance of the conventional Ag electrode.

In the solar cell, mainly light beams on the short-wavelength side among light beams incident from the substrate are directly absorbed by the photoelectric conversion layer and contribute to the photoelectric conversion, and thus they do not reach the second electrode and the remaining light beams on the long-wavelength side are transmitted through the photoelectric conversion layer and the buffer layer and reach the second electrode. Accordingly, high optical reflection on the long-wavelength side of the second electrode 16 means that it is possible to efficiently return the light transmitted through the photoelectric conversion layer 14 to the photoelectric conversion layer 14 and the incident photon-to-current conversion Efficiency can be securely improved.

By forming the second electrode 16 with the alloy including Ag as a main component with Sn and Au added thereto, reflectance on the long-wavelength side can be increased and the intensity of reflected light entering the photoelectric conversion layer 14 can be thereby increased, and thus the incident photon-to-current conversion efficiency of the solar cell 10 can be improved. The high optical reflectance on the long-wavelength side is particularly effective in a tandem structure in which amorphous silicon and microcrystal silicon are laminated. This is because the microcrystal silicon generates electricity by light on the long-wavelength side.

### [Adhesion of Alloy Electrode 16 with respect to Buffer Layer 15]

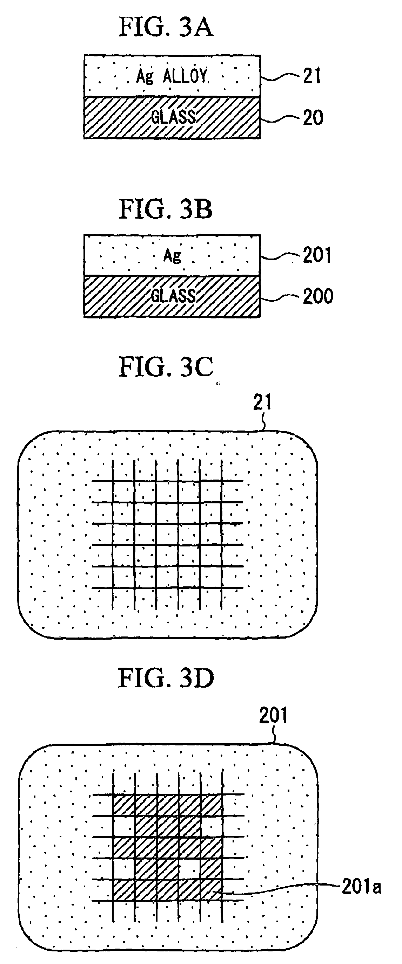

FIGS. 3A to 3D are drawings explaining a peel test (seal test) for evaluating the adhesion of the ASA film constituting the second electrode 16 of the solar cell 10. FIG. 3A is a cross-sectional diagram of a sample A in which an ASA film 21 is formed on a glass substrate 20 by sputtering. FIG 3B is a cross-sectional diagram of a sample B in which an Ag film 201 having the same film thickness as that of the above-mentioned ASA film is formed on a glass substrate 200 (which is the same as the glass substrate 20) by sputtering. FIG 3C is a top view showing the result of the peel test of the above-mentioned sample A and FIG 3D is a top view showing the result of the peel test of the above-mentioned sample B.

In the above-mentioned peel test, the ASA film and the Ag film of the samples A and B were divided into 5×5 grids by a cutter to obtain 25 film pieces from each. On the ASA film and the AG film, which were divided into the film pieces, an adhesive such as an adhesive tape was adhered and the adhesive was peeled off. At this time, by the number of film pieces adhered to the adhesive and peeled off from the glass substrate, adhesion of the respective films was evaluated. In the samples A and B, the same adhesives (adhesives having the same adhesive power) were used and peeled off by the same force. In addition, in this evaluation, the adhesion with the glass substrate is evaluated. However, in another test, the same tendency is obtained in adhesion between the glass substrate and the TCO (AZO, GZO or the like), so it can be said that the result of this evaluation directly reflects the adhesion with the AZO or GZO film constituting the buffer layer 15.

As shown in FIG 3C, in the ASA film 21 used in the second electrode 16 of the present invention of the sample A, all of the 25 film pieces remain on the substrate 20. On the other hand, as shown in FIG 3D, in the Ag film of the sample B, which is used in the conventional second electrode, there are 21 regions 201a, at which the film piece was peeled off, on the substrate 200, and only 4 film pieces remain. From this peel test, it was found that adhesion between the buffer layer 15 and the second electrode (alloy electrode) 16 composed of the ASA film in the solar cell 10 of this embodiment is superior to the adhesion with the second electrode composed of the Ag film in the conventional solar cell. The improvement in adhesion is achieved by adding Sn. It is thought that Sn forms an oxide at the interface between the second electrode and the buffer layer 15 and thus the adhesion is increased. In addition, since SnO is transparent and has conductive properties, influence with respect to the reflectance is small and the resistance is also hardly lowered. Accordingly, even when an Ag alloy film including Ag as a main component with Sn added thereto and no addition of Au is used, the above-mentioned adhesion improvement is obtained.

As described above, by forming the second electrode 16 with the alloy including Ag as a main component with Sn and Au added thereto, the adhesion between the second electrode 16 and the buffer layer 15 can be improved. As a result, since the contact resistance (interface resistance) of the interface between the second electrode and the buffer layer 15 can be decreased, the incident photon-to-current conversion efficiency of the solar cell can be improved.

### [Incident Photon-to-Current Conversion Efficiency of Solar Cell 10]

A plurality of the solar cells 10 were manufactured by changing the flow of argon gas in performing sputtering for forming the alloy electrode (second electrode 16) including Ag with Sn and Au added thereto. Among some of the solar cells 10, incident photon-to-current conversion efficiency was improved by about 7% as compared to the conventional solar cell having an Ag electrode as the second electrode 16. As shown in the following Table 1, it was confirmed that short-circuit current, open voltage, fill factor were also equal to or improved compared to the conventional case.
In Table 1, values of the solar cell of this embodiment which has an ASA electrode as the second electrode 16 are shown when values in the conventional solar cell which has an Ag electrode as the second electrode 16 are set to 100 (%).

**Table 1**

| Second Electrode | Short-Circuit Current | Open Voltage | Fill Factor | Conversion Efficiency |
|---|---|---|---|---|
| Ag | 100 | 100 | 100 | 100 |
| ASA | 104 | 100 | 102 | 107 |

### [Corrosion Resistance of Alloy Electrode 16]

In order to confirm the corrosion resistance of the ASA film, the sample A (in which the ASA film 21 was formed on the glass substrate 20 by sputtering) shown in FIG 3A and the sample B (in which an Ag film having the same film thickness as that of the ASA film of the sample A was formed on the same glass substrate as in the sample A) as a comparative example shown in the above-mentioned FIG. 3B were provided. These samples were dipped in saline water having a salt content of 5% for 96 hours and then the surfaces of both of the samples were visually observed.

In the sample B in which the Ag film constituting the conventional second electrode was formed, Ag was reacted with the saline water and thus a corroded portion was observed in the Ag film. On the other hand, in the sample A in which the ASA film 21 constituting the second electrode (alloy electrode) 16 of this embodiment was formed, a corroded portion did not present itself in the ASA film 21 and no corrosion change was confirmed. The improvement in corrosion resistance is achieved by adding Au. Accordingly, even when an Ag alloy film including Ag as a main component with Au added thereto and no addition of Sn is used, the above-mentioned corrosion resistance improvement is obtained.

As described above, by forming the second electrode 16 with the alloy including Ag as a main component with Sn and Au added thereto, the corrosion resistance of the second electrode (alloy electrode) 16 can be improved. Accordingly, a decrease in reflectance due to the corrosion of the alloy electrode 16 can be prevented, and a decrease in contact resistance due to deterioration in adhesion at the interface between the second electrode and the buffer layer 15 can be prevented. As a result, it is possible to secure a stable high reflectance with little deterioration and it is possible to secure stabilized adhesion with no deterioration.

### [Coverage of Alloy Electrode 16]

It is preferable that the respective layers constituting the photoelectric conversion body 12, which are the first electrode (transparent electrode) 13, the n-i-p silicon film of the photoelectric conversion layer 14, the buffer layer 15 and the second electrode (alloy electrode) 16 composed of the ASA film 21, employ a texture structure in which irregularities are formed on the front and back surfaces. In this case, since a prism effect extending the optical path of sunlight entering the respective layers and a confinement effect of light can be obtained, the incident photon-to-current conversion efficiency of the solar cell 10 can be further improved.

If the coverage of the ASA film which is formed on the buffer layer 15 having such a texture structure further deteriorates than in the conventional Ag film, it becomes a factor in a decrease in adhesion with the buffer layer 15.
However, even when the ASA film 21 which is used as the second electrode 16 in this embodiment is formed on the buffer layer 15 having a texture structure, the same coverage as in the conventional Ag film is obtained. Accordingly, adhesion with the buffer layer 15 having a texture structure can be secured at the same or a higher level than in the conventional case.

The solar cell 10 of FIG. 1 is a single solar cell in which the photoelectric conversion layer 14 employs a single structure. However, the present invention also can be applied to a tandem solar cell in which the photoelectric conversion layer employs a tandem structure. In addition, the above-mentioned solar cell 10 is exemplified by a so-called super-straight-type in which light is incident from the transparent substrate. However, even when a so-called substrate-type in which the alloy electrode (second electrode) 16, the buffer layer 15, the photoelectric conversion layer 14 and the first electrode (surface transparent electrode) 13 are formed on a substrate such as glass, an insulating material or a film is employed, the alloy electrode (second electrode) 16 of this embodiment can be applied.

### [Buffer Layer 15 having Low Refractive Index]

In addition, in the solar cell 10 of FIG. 1, the buffer layer 15 also can be formed of a conductive material having a low refractive index. For example, when GZO is used as the buffer layer 15, the refractive index of the GZO film is 2.05. However, the buffer layer also can be formed of a material having a refractive index equal to or less than 2.0.

The buffer layer 15 composed of a GZO film also functions as a reflection layer for reflecting some of the light beams entering and transmitted through the photoelectric conversion layer 14 toward the photoelectric conversion layer 14, but not directing the above light beams toward the alloy electrode 16.
However, since the refractive index of the silicon film constituting the photoelectric conversion layer 14 is in the range of 3.8 to 4.0, the light beams which can be reflected are limited to light beams of which the incident angle is small. By decreasing the refractive index of the buffer layer 15 and thereby increasing the difference in the refractive index with the silicon film, some of light beams incident at a small incident angle from the photoelectric conversion layer 14 can be reflected. As a result, the incident photon-to-current conversion efficiency can be further improved without the reflection of these light beams by the alloy electrode 16.

As the buffer layer 15 having such a low refractive index, for example, there is a silicon oxide film doped with n-type impurities such as phosphorus (P), arsenic (As), antimony (Sb), bismuth (Bi), lithium (Li) and magnesium (Mg) for a case in which the buffer layer is formed on an n-type amorphous silicon film. In addition, for example, there is a silicon oxide film doped with p-type impurities such as boron (B), gallium (Ga), aluminum (Al), indium (In), thallium (T1) and beryllium (Be) for a case in which the buffer layer is formed on a p-type amorphous silicon film.

In the above-described embodiment, the case in which an ASA film including Ag as a main component with Sn and Au contained therein is used as the second electrode has been described as an example. However, according to the present invention, an Ag alloy film including Ag as a main component with only one of Sn and Au contained therein also can be used as the second electrode.

### INDUSTRIAL APPLICABILITY

In a solar cell of the present invention, as the material for a second electrode, an alloy including Ag as a main component with Sn and Au added thereto is used. In this manner, reflectance of the metal electrode itself can be improved and adhesion with a buffer layer can be improved. Accordingly, since an increase in contact resistance at the interface is suppressed and incident photon-to-current conversion efficiency can thus be improved, the incident photon-to-current conversion efficiency and reliability of the solar cell can be improved (the adhesion is improved by adding Sn and the reflection characteristics and the corrosion resistance are improved by adding Au).

### [Brief Description of the Reference Symbols]

- 10:: SOLAR CELL
- 11:: SUBSTRATE
- 11a:: BACK SURFACE OF SUBSTRATE
- 11b:: SURFACE OF SUBSTRATE
- 12:: PHOTOELECTRIC CONVERSION BODY
- 13:: FIRST ELECTRODE (SURFACE ELECTRODE)
- 14:: SEMICONDUCTOR LAYER (PHOTOELECTRIC CONVERSION LAYER)
- 15:: BUFFER LAYER
- 16:: SECOND ELECTRODE (BACK SURFACE ALLOY ELECTRODE)
- 17:: PROTECTIVE LAYER

## Claims

1. A solar cell comprising:
a light transmissive first electrode;
a photoelectric conversion layer formed of silicon;
a light transmissive buffer layer; and
a second electrode formed of a light reflective alloy,
wherein the second electrode is formed of a silver alloy including silver (Ag) as a main component with at least one of tin (Sn) and gold (Au) contained therein.

2. The solar cell according to Claim 1,
wherein the silver alloy is formed of a material including Ag as a main component with 0.1 to 2.5 of Sn contained therein in terms of atom% units (at%).

3. The solar cell according to Claim 1,
wherein the silver alloy is formed of a material including Ag as a main component with 0.1 to 4.0 of Au contained therein in terms of atom% units (at%).

4. The solar cell according to Claim 1,
wherein the silver alloy is formed of a material including Ag as a main component with 0.1 to 2.5 of Sn and 0.1 to 4.0 of Au contained therein in terms of atom% units (at%).

5. A method of manufacturing the solar cell according to Claim 1, the method comprising:
forming by sputtering the second electrode using a target including Ag and at least one of Sn and Au.

6. The solar cell manufacturing method according to Claim 5,
wherein the target is formed of a material including Ag as a main component with 0.1 to 2.5 of Sn contained therein in terms of atom% units (at%).

7. The solar cell manufacturing method according to Claim 5,
wherein the target is formed of a material including Ag as a main component with 0.1 to 4.0 of Au contained therein in terms of atom% units (at%).

8. The solar cell manufacturing method according to Claim 5,
wherein the target is formed of a material including Ag as a main component with 0.1 to 2.5 of Sn and 0.1 to 4.0 of Au contained therein in terms of atom% units (at%).
